# EUROPEAN PATENT APPLICATION

(11) **EP 1 014 487 A1**
(43) Date of publication of application: **28.06.2000**
(21) Application number: 98124589.7
(22) Date of filing: 23.12.1998
(51) Int. Cl.: H01Q 9/04

(54) **Patch antenna and method for tuning a patch antenna**

(71) Applicant: Sony International (Europe) GmbH, 50829 Köln (DE)
(72) Inventor: Khan, Haroon, c/o Sony International (Europe) GmbH, 85609 Aschheim-Dornach (DE); Peinl, Gerhard, c/o Sony Internat.(Europe) GmbH, 85609 Aschheim-Dornach (DE)
(74) Representative: Körber, Martin, Dipl.-Phys.

(57) **Abstract**

The present invention relates to a patch antenna and a method for tuning a patch antenna. The patch antenna comprises a ground element (4) being electrically conductive and a resonator element (1) being electrically conductive. Further provided is a solid dielectric element (2), whereby said resonator element (1) is located on a first side of said dielectric element (2) and said ground element (4) is located on a second side of said dielectric element (2) opposite to said first side. At least two tuning pads (3a, 3b, 3c) are provided, which are electrically conductive and located on said first side of said dielectric element (2) for tuning the resonance frequency of the patch antenna. Said at least two tuning pads (3a, 3b, 3c) are designed to be electrically connected to said resonator element (1) by applying an electrically conductive material (5, 6), so that the resonance frequency of the patch antenna is tuned to a required resonance frequency.

## Description

The present invention relates to a patch antenna and a method for tuning a patch antenna. The patch antenna of the present invention is particularly suited for applications in portable devices, e. g. in GSM mobile phones.

Many applications require small, lightweight and efficient conformal antennas. Patch antennas such as microstrip patch antennas have been a preferred type for many applications. However, patch antennas typically are efficient only in a narrow frequency band. On the other hand, the advantages of patch antennas are that they are mountable in a small space, have a high gain and can be constructed in a rugged form.

WO 95/24745 discloses an antenna for a handheld transceiver, whereby the antenna comprises an electrically conductive ground element, an electrically conductive resonator element and a solid dielectric element located between the ground element and the resonator element. The area of the resonator element is smaller than the area of the ground element. The resonator element comprises a projection. By milling away an appropriate amount of the length of the projection the resonant frequency of the patch antenna can be tuned.

US 5 777 581 discloses a microstrip patch antenna for satellite applications in the UHF band of 240 to 320 MHz. The microstrip patch antenna includes an electrically conductive patch as resonator element, which is generally parallel to and spaced from an electrically conducting ground plane by a dielectric element. Conductive strips are located surrounding the patch. Particular circuitry is provided to selectively connect or isolate the strips from the patch. A strip connected to the patch effectively increases the area of the patch and lowers the resonance frequency of the entire antenna. The circuitry for selectively connecting and isolating the strips to and from the patch comprise e. g. diodes. By switching the diodes on or off, one or more strips can be connected to the patch for tuning the resonance frequency of the antenna. Thereby, the resonance frequency can be tuned to several different frequencies. Other proposed switching components include PIN diodes, FETs, bulk switchable semiconductors, relais and mechanical switches for bridging the gaps between the patch element and the conducting metal strips. Thus, the configuration of the proposed microstrip patch antenna is complex and requires a costly manufacturing process.

The object of the present invention is therefore to provide a patch antenna having a resonance frequency, comprising a ground element being electrically conductive, a resonator element being electrically conductive, a solid dielectric element, whereby said resonator element is located on a first side of said dielectric element and said ground element is located on a second side of said dielectric element opposite to the first side, and at least two tuning pads being electrically conductive and located on said first side of said dielectric element for tuning the resonance frequency, which has a simple but effective configuration and can be produced with low costs in mass production. A further object of the present invention is to provide a method for tuning such a patch antenna, which allows a simple and effective tuning of the resonance frequency of such a patch antenna.

The first above-mentioned object is solved by a patch antenna according to claim 1, which is characterized in that at least two tuning pads are designed to be electrically connected to said resonator element by applying of an electrically conductive material. In contrast to the above described known patch antenna, in which switch means are fixedly provided to selectively connect or isolate tuning pads to or from the resonator element for tuning the antenna to one of a plurality of different possible resonance frequencies, the present invention provides a simple and cheap configuration for a patch antenna tunable to a single resonance frequency. In a first step, the patch antenna is produced comprising at least two tuning pads. In a second production step, an electrically conductive material is applied or deposited selectively to connect the resonator element selectively to the necessary pad/pads to tune the patch antenna to the required resonance frequency. Thereby production tolerances in the patch antenna dimensions can be balanced in a simple and effective way to achieve the required resonance frequency.

The above-mentioned second object is achieved by providing a method for tuning a patch antenna according to claim 12, which is characterized by the steps of measuring a current resonance frequency of the patch antenna and connecting at least one tuning pad and the resonator element by means of an electrically conductive material to tune the current resonance frequency of the patch antenna to a desired resonance frequency. Thus, the present invention provides a simple and effective method for tuning the patch antenna to tune a current resonance frequency of the antenna after a first production step to a required resonance frequency. The electrically conductive material can be applied selectively dependent on the measured current resonance frequency to increase the effective size of the resonator element and consequently to lower the resonance frequency of the patch antenna.

Particularly in contrary to the antenna disclosed in US 5 777 581 the present invention provides for a tunable patch antenna, which can be produced at low cost in mass production. The patch antenna according to the present invention is thereby designed to be tuned to a single required resonance frequency. Production tolerances occuring during the mass production of the antennas can be diminished by measuring the current resonance frequency of the patch antenna and to tune the patch antenna to the required resonance frequency by respectively connecting one or more tuning pads to the resonator element. The antenna disclosed in US 5 777 581 is in contrast thereto designed to be tuned to different resonance frequencies.

According to one aspect of the present invention, the at least two tuning pads are designed to be directly connected to the resonator element by applying said electrically conductive material. In this case, the electrically conductive material can be applied directly between the resonator element and the corresponding tuning pad/pads.

In an alternative aspect of the present invention, a resonator element is electrically connected to at least two electrically conducting connector pads, whereby the at least two tuning pads are designed to be connected to a respective connector pad by said conductive material. This case is particularly advantageous in applications, in which a direct contact of the resonator element with the conductive material should be avoided. The connector pads are electrically connected to the resonator element already in the first production step and serve as connecting links between the resonator element and the connected tuning pads. The isolating gap between the connector pads and the tuning pads can be very small, so that a small amount of electrically conductive material is sufficient to connect the tuning pad. Further, special provisions can be made to ensure a better and longer lasting electrical contact between the tuning pad and the corresponding connector pad without affecting the main part of the resonator element. The size of the connector pads is advantageously smaller than the size of the respectively allocated tuning pads.

Advantageously, the at least two tuning pads are co-planar to said resonator element. Further, the tuning pads can have different sizes, so that the patch antenna can be tuned accurately to the required resonance frequency.

This feature is particularly advantageous, since patch antennas according to the present invention produced at low cost in mass production can, under bad circumstances, have a broad tolerance range in view of the resonance frequency. In this case it is necessary, to provide tuning pads having different sizes to be able to selectively tune the mass produced patch antennas to the required resonance frequency.

Further advantageously, said resonator element, said ground element, said at least two tuning pads and said at least two connector pads, respectively, are thin metal films, and said solid dielectric element is a dielectric layer, onto which said thin metal films are printed. Thus, the patch antenna or at least a part of the patch antenna of the present invention can be produced in form of a printed circuit board so that the production costs can be significantly lowered. Even if the dimensional tolerances of the patch antenna are not precise in this case due to the low cost production, the efficient and simple tuning possibility still enables to tune the resonant frequency of the antenna precisely.

Further advantageously, said resonator element and said ground element are electrically connected at a first end of the patch antenna, so that a shorted end is formed at said first end. The resonator element and the ground element are thereby not electrically connected at a second end of said patch antenna opposite to said first end, so that an open end is formed at said second end. The open end is thus the transmitting and receiving part of the antenna. The open end can be regarded as a capacitive part and the closed end can be regarded as an inductive end of the antenna. The at least two tuning pads are advantageously positioned close to said open end, so that the capacitive part as the more densible part of the antenna can be influenced and the resonance frequency of the antenna can be tuned by connecting one or more tuning pads to the resonator element.

Advantageously, at least one of the tuning pads is electrically connected to the resonator element by means of the electrically conductive material. Since the present invention provides a way to tune a mass produced patch antenna to the required resonance frequency only in one direction, the patch antennas can e. g. be designed and produced to have a generally higher resonance frequency than later required during use of the antenna. In other words, the area of the resonator element is chosen to be smaller than actually necessary for the required resonance frequency. Since the patch antenna thus has generally a higher resonance frequency than required after production, at least one of the tuning pads has to be connected by means of the electrically conductive material to the resonator element to enlarge the effective size of the resonator element and thus to lower the resonance frequency of the antenna to the required value. In this way, the disadvantage of the high resonance frequency tolerances of a mass produced patch antenna according to the present invention can be turned into an advantage by "biasing" the resonance frequency of the antenna to a higher value and selectively connect one or more tuning pads to the resonator element by means of the electrically conductive material.

Advantageously, said electrically conductive material is a material having a solid state at room temperature and a fluid state at a temperature different from said room temperature. Such a kind of a conductive material provides a simple and efficient way to selectively connect one or more tuning pads with the resonator element. In this case, the conductive material can e. g. be solder or an electrically conductive clue.

The present invention is described in the following in more detail by means of preferred embodiments relating to the enclosed drawings, in which
figure 1 shows a top view of a first embodiment of a patch antenna according to the present invention,
figure 2 shows the patch antenna of figure 1 with one of the tuning pads connected to the resonator plane.
figure 3 shows a cross-sectional view of the patch antenna shown in figure 2,
figure 4 shows a top view of a second embodiment of a patch antenna according to the present invention, and
figure 5 shows a sectional view of the patch antenna shown in figure 4.

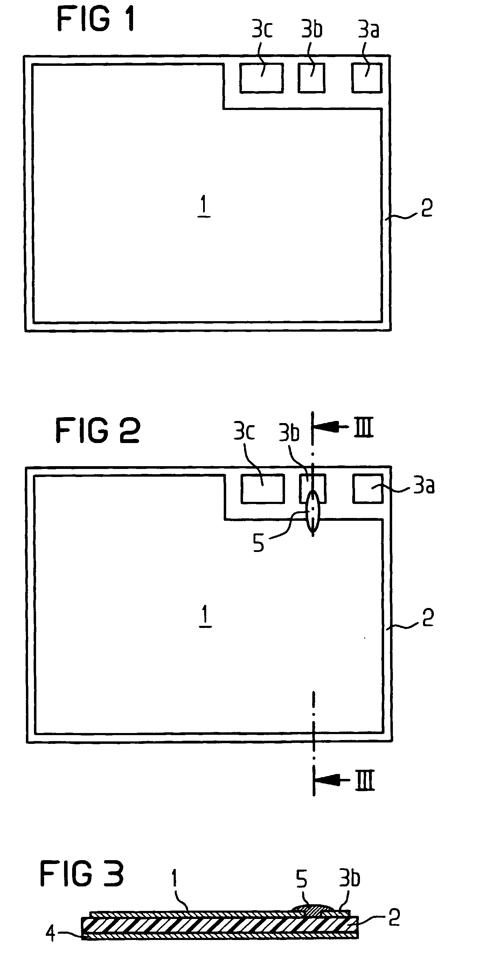

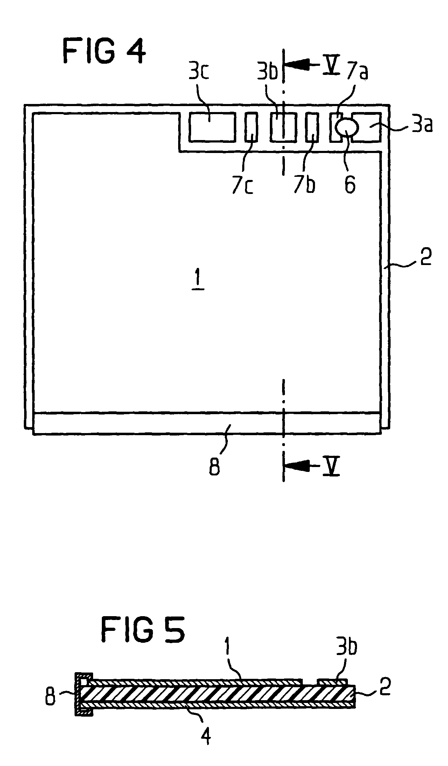

Figure 1, figure 2 and figure 3 show a first embodiment of the patch antenna according to the present invention and figure 4 and figure 5 show a second embodiment of the patch antenna according to the present invention.

Although the shown patch antennas are designed to be used in a GSM mobile phone, it is to be understood, that the antennas can be used also in other application, in which lightweight, efficient and low cost antennas are required. Applications in portable devices require lightweight and small antennas. Small antennas to be integrated in a portable device have necessarily a high Q-value and thus a small frequency bandwidth. The Q-value is the ratio between the resonance frequency and the frequency bandwidth of the antenna. The Q-value is a property of the antenna, which depends mainly on the antenna volume. Thus, if the antenna has to be an integrated antenna for a portable device, the Q-value becomes large and therefore the frequency bandwidth becomes small.

However, e. g. in GSM-applications, the required bandwidth is 960 MHz - 890MHz = 70MHz. The center frequency for this frequency band is 925 MHz. Antennas, particularly antennas produced at low cost in mass production, usually tend to have larger tolerances instead of high precision values. A variation of the dimensional tolerances of the antenna leads to a tolerance of the resonance frequency of the antennas. If, e. g. the tolerance of the resonance frequency of an antenna is ± 1%, the required frequency bandwidth would be increased from the ideal 70 MHz to about 88,5 MHz. A frequency tolerance of ± 1 % means ± 1 % × 925 MHz = ± 9,25 MHz, which results in an increased bandwidth of (2 × 9,25) MHz + 70 MHz = 88,5 MHz.

The frequency bandwidth of an antenna with a given Q-value can be increased by proper matching, but only within some limits. The matching loss thereby increases with an increasing frequency bandwidth to be matched.

Thus, the resonance frequency tolerance resulting from dimensional tolerances of a patch antenna is a very critical subject. The patch antenna according to the present invention provides an easy, cheap and very effective way to tune the current resonance frequency of a mass produced patch antenna to a required resonance frequency.

Figure 1 shows a top view of a first embodiment of a patch antenna according to the present invention. Figure 2 shows the patch antenna of figure 1, whereby one of the tuning pads is connected to the resonator element. Figure 3 shows a cross-sectional view along line III-III of the patch antenna shown in figure 2.

The patch antenna comprises a resonator plane 1 as resonator element and a ground plane 4 as a ground element. The resonator plane 1 as well as the ground plane 4 consists of an electrically conductive material, e. g. metal. A dielectric layer 2 formed of a solid dielectric material is provided between the resonator plane 1 and the ground plane 4. In the shown embodiment, the resonator plane 1 is a thin metal film, which is printed onto a first side of the dielectric layer 2. Similarly, the ground plane 4 is a thin metal film which is printed onto a second side of the dielectric layer 2 opposite to said first side. In this case, the shown patch antenna can be produced as a printed circuit board at low cost in mass production.

Printing the resonator plane 1 and the ground plane 4 onto the dielectric layer 2 has the advantage that the distance between the resonator plane 1 and the ground plane 4, which is the height of the antenna, can be set accurately. In the shown embodiment, the length and the width of the resonator plane 1 and the ground plane 4 as well as the dielectric layer 2 are essentially the same. However, the ground plane 4 can have a length larger than the length of the resonator plane 1. If the physical length of the resonator plane 1 corresponds approximately to a quarter wavelength of the resonance frequency, the physical length of the ground plane 4 can e. g. correspond generally to a half wavelength of the resonance frequency. Further, the patch antenna shown in figure 1 can e. g. be part of a larger antenna element, whereby the resonator plane 1 is in contact with a corresponding resonator part of the antenna element and the ground plane 4 is in contact with a corresponding ground part of the antenna element.

In the literature, patch antennas are often discussed and theoretically explained as a type of a microstrip antenna over an infinite ground plane. This means that the resonator plane, which is called a patch, has a size much smaller than the ground plane spaced from the resonator plane by a small distance, e. g. one cm. In the present case, however, a patch antenna is proposed, in which the ground plane 4 does not have an infinite size compared to the resonator plane 1, but has generally the same size or depending on the application the double or triple size of the resonator plane 1. A patch antenna of the present invention, however, corresponds to microstrip type patch antennas in that the resonator plane is essentially parallel to the ground plane and spaced by a small distance. By use of a dielectric material between the ground plane and the resonator plane, the height of the antenna can be made smaller due to the dielectric constant larger than 1 and the low distance between the resonator plane and the ground plane 4 can be set accurately, e. g. by printing of thin metal films onto the dielectric.

The patch antenna of the present invention comprises tuning pads 3a, 3b and 3c, which are located on the side of the resonator plane 1 and serve for tuning the resonance frequency of the patch antenna. In the embodiments shown in the present application, the tuning pads 3a, 3b and 3c are co-planar to the resonator plane 1 and are formed of thin metal films printed onto the dielectric layer 2 side by side to the resonator plane 1. As can be seen in figure 1, figure 2 and figure 4, the tuning pads 3a, 3b and 3c are located at one corner area of the patch antenna. Between the tuning pads 3a, 3b and 3c and the resonator plane 1, respectively, an isolating gap is provided. The tuning pads 3a, 3b and 3c are designed to be electrically connected to the resonator element 1 by applying an electrically conductive material. This means, that the tuning pads 3a, 3b and 3c are isolated from and spaced to the resonator element 1 only by a small distance and by applying or depositing a conductive material, e. g. solder or an electrically conducting glue, one or more of the tuning pads 3a, 3b and 3c can be connected to the resonator element 1 to tune the resonance frequency of the patch antenna. Thereby, after producing the patch antenna as shown in figure 1, the current resonance frequency of the produced patch antenna is measured. In case that the current resonance frequency corresponds to the required resonance frequency, none of the tuning pads 3a, 3b or 3c is connected to a resonator plane 1. However, if the measured resonance frequency differs from the required resonance frequency, one or more of the tuning pads 3a, 3b and 3c are connected to the resonator plane 1 to adapt the resonance frequency to the required value. Connecting one of the tuning pads 3a, 3b or 3c to the resonator plane 1 means an increase of the effective size of the resonator plane 1 and consequently a lower resulting resonance frequency of the entire patch antenna.

Figure 2 shows the patch antenna of figure 1, whereby the tuning pad 3b is connected by a electrically conductive material 5 to the resonator plane 1. In the shown case, the electrically conductive material directly connects the tuning pad 3b and the resonator plane 1.

The conductive material 5 can e. g. be solder, electrically conductive clue or another similar material, which has a solid state at room temperature and a fluid state at a temperature different from room temperature. In this way, the patch antenna according to the present invention can be mass produced, whereby in a first step the thin metal films of the tuning pads 3a, 3b, 3c, the resonator plane 1 and the ground plane 4 are printed onto the dielectric layer 2, in a second step the current resonance frequency of the respective patch antenna is measured, and then, in a third step, one or more of the tuning pads 3a, 3b, 3c is electrically connected to the resonator plane 1 by applying or depositing conductive material 5 to tune the current resonance frequency to the required resonance frequency.

As shown in figures 1, 2 and 4, the tuning pads 3a, 3b and 3c have different sizes, so that the resonance frequency can be precisely tuned. In the region where the conductive material 5 is to be deposited, the tuning pads 3a, 3b and 3c and the resonator plane 1 can be covered by a layer of an electrically conductive covering material to improve the connection between the tuning pads 3a, 3b, 3c and the resonator plane 1, when the conductive material 5 is applied.

Figure 3 shows a cross-sectional view along line III-III of figure 2. Figure 3 thereby shows clearly, how the conductive material 5 directly connects the tuning pad 3b and the resonator plane 1.

In the second embodiment shown in figures 4 and 5, the same reference numerals as in the first embodiment shown in figures 1, 2 and 3 are used for the same elements and an explanation thereof is omitted. The general remarks relating to the first embodiment and the technical features explained in relation to the first embodiment apply in the same way to the second embodiment shown in figures 4 and 5.

The second embodiment has to main differences to the first embodiment. The first difference is, that the resonator plane 1 and the ground plane 4 are electrically connected by a connecting element 8 at one end of the patch antenna, so that a closed end is formed, as can be seen in figure 4. The end opposite to this closed end is an open end, which means that the ground plane 4 and the resonator plane 1 are not electrically connected at this end. At the open end, the tuning pads 3a, 3b and 3c are provided.

In patch antenna theory, the closed end can be regarded as an inductive part of the antenna, whereas the open end can be regarded as a capacitive part of the antenna. The open end thereby is the radiating and receiving part of the antenna. The resonance frequency of the antenna is strongly influenced by the overlap area between the resonator plane 1 and the ground plane 4 in the region of the open end. Thus, electrically connecting additional tuning pads 3a, 3b or 3c influences the resonator frequency of the patch antenna, which consequently can be tuned effectively and precisely to a desired resonance frequency.

In the second embodiment shown in figures 4 and 5, additional connector pads 7a, 7b and 7c are provided, which are steadily connected to the resonator plane 1 by a respective electrically conducting wire on microstrip 9. The tuning pads 3a, 3b and 3c are located side by side to a respective connector pad 7a, 7b and 7c. Thereby, an isolating gap is provided between the tuning pads 3a, 3b, 3c and the resonator plane 1 and the respective connector pad. As in the first embodiment, the tuning pads 3a, 3b and 3c are designed to be electrically connected to the resonator plane 1 by applying a conductive material 5, 6. Thereby, the tuning pads 3a, 3b and 3c are isolated from and spaced to their respective connector pads 7a, 7b and 7c by a small distance, which allows to apply an electrically conductive material in a quick and effective way.

The tuning pad 3a is shown as being electrically connected to the allocated connector pad 7a by a conductive material 6, which can e. g. be solder or electrically conducting clue as the conductive material 5 of the first embodiment. The connector pad 7a, 7b and 7c provide an easier and more efficient possibility of connecting the tuning pads 3a, 3b and 3c to the resonator plane 1, without a requirement of a direct connection between the tuning pads 3a, 3b, 3c and the resonator plane 1.

Particularly, the connector pads 7a, 7b and 7c as well as the tuning pads 3a, 3b and 3c can be covered with a covering material which enables a better and more durable connection between the tuning pads and the connector pads. If, e. g. solder is used as electrically conductive material 6, the covering material can be provided, which ensures that solder drops are formed in a precise and lasting manner for ensuring a reliable electrical connection between the tuning pads and the respective connector pad. The tuning pads 3a, 3b and 3c have respectively different sizes to enable an effective and precise tuning of the resonance frequency.

It is to be noted, that the patch antenna of the first embodiment shown in figures 1, 2 and 3 could also comprise a connecting element 8 forming a closed end at one end of the patch antenna, as the second embodiment. Further, the patch antenna of the second embodiment shown in figures 4 and 5 could also be formed without the connecting element 8 like the patch antenna of the first embodiment.

## Claims

1. Patch antenna having a resonance frequency, comprising
a ground element (4) being electrically conductive,
a resonator element (1) being electrically conductive,
a solid dielectric element (2), whereby said resonator element (1) is located on a first side of said dielectric element (2) and said ground element (4) is located on a second side of said dielectric element opposite to said first side,
at least two tuning pads (3a, 3b, 3c) being electrically conductive and located on said first side of said dielectric element (2) for tuning the resonance frequency,
**characterized in,**
that said at least two tuning pads (3a, 3b, 3c) are designed to be electrically connected to said resonator element (1) by applying an electrically conductive material (5, 6).

2. Patch antenna according to claim 1,
**characterized in,**
that said at least two tuning pads (3a, 3b, 3c) are designed to be directly connected to said resonator element (1) by applying said electrically conductive material (5, 6).

3. Patch antenna according to claim 1,
**characterized in,**
that said resonator element (1) is electrically connected to at least two electrically conducting connector pads (7a, 7b, 7c), whereby said at least two tuning pads are designed to be connected to a respective connector pad (3a, 3b, 3c) by applying said conductive material (5, 6).

4. Patch antenna according to claim 1, 2 or 3
**characterized in,**
that said at least two tuning pads (3a, 3b, 3c) are coplanar to said resonator element (1).

5. Patch antenna according to one of the claims 1 to 4,
**characterized in,**
that said at least two tuning pads (3a, 3b, 3c) have different sizes.

6. Patch antenna according to one of the claims 1 to 5,
**characterized in,**
that said resonator element (1), said ground element (4), said at least two tuning pads (3a, 3b, 3c) and said at least two connector pads (7a, 7b, 7c), respectively, are thin metal films and said solid dielectric element (2) is a dielectric layer consisting of a solid dielectric material located between said resonator element and said ground element, whereby said thin metal films are printed onto said dielectric layer.

7. Patch antenna according to one of the claims 1 to 6,
**characterized in,**
that said resonator element (1) and said ground element (4) are electrically connected at a first end of the patch antenna so that a shorted end is formed at said first end and that said resonator element and said ground element are not electrically connected at a second end of said patch antenna opposite to said first end so that an open end is formed at said second end, whereby said at least two tuning pads are positioned close to said open end.

8. Patch antenna according to one of the claims 1 to 6,
**characterized in,**
that at least one tuning pad is electrically connected to said resonator element by means of an electrically conductive material (5, 6).

9. Patch antenna according to claim 8,
**characterized in,**
that said electrically conductive material (5, 6) electrically connecting said resonator element (1) and said at least one tuning pad (3a, 3b, 3c) is a material having a solid state at room temperature and a fluid state at a temperature different from room temperature.

10. Patch antenna according to claim 9,
**characterized in,**
that said electrically conductive material (5, 6) is solder deposited between said resonator element and said at least on tuning pad.

11. Patch antenna according to claim 9,
**characterized in,**
that said electrically conductive material (5, 6) is electrically conductive glue deposited between said resonator element and said at least on tuning pad.

12. Method for tuning a patch antenna having a resonance frequency, said patch antenna comprising
a ground element (4) being electrically conductive,
a resonator element (1) being electrically conductive,
a solid dielectric element (2), whereby said resonator element is located on a first side of said dielectric element and said ground element is located on a second side of said dielectric element opposite to said first side,
at least two tuning pads (3a, 3b, 3c) being electrically conductive and located on said first side of said dielectric element for tuning the resonance frequency,
**characterized by**
the steps of measuring a current resonance frequency of the patch antenna and connecting at least one tuning pad (3a, 3b, 3c) and said resonator element (1) by means of an electrically conductive material (5, 6) to tune the current resonance frequency of the patch antenna to a desired resonance frequency.

13. Method for tuning an patch antenna according to claim 12,
**characterized in,**
that said electrically conductive material (5, 6) for electrically connecting said resonator element and said at least one tuning pad is a material having a solid state at room temperature and a fluid state at a temperature different from room temperature, whereby said step of connecting said at least one tuning pad (3a, 3b, 3c) and said resonator element (1) consists of depositing said electrically conducting material between said at least one tuning pad and said resonator element in said fluid state.

14. Method for tuning a patch antenna according to claim 13,
**characterized in,**
that said electrically conductive material (5, 6) is solder.

15. Method for tuning a patch antenna according to claim 13,
**characterized in,**
that said electrically conductive material (5, 6) is electrically conductive glue.
